# DEMANDE DE BREVET EUROPEEN

(11) **EP 4 350 444 A1**
(43) Date de publication de la demande: **10.04.2024**
(21) Numéro de dépôt: 23202437.2
(22) Date de dépôt: 09.10.2023
(51) Int. Cl.: G03F 7/40, G03F 7/00, C25D 5/02, G03F 7/38

(54) **MOULE POUR LA FORMATION DE PIÈCES MÉTALLIQUES PAR CROISSANCE MÉTALLIQUE ET PROCÉDÉ DE FABRICATION D'UN TEL MOULE**

(30) Priorité: 07.10.2022 EP 22200413
(71) Demandeur: Richemont International S.A., 1752 Villars-sur-Glâne (CH)
(72) Inventeur: CHABART, Mickaël, 2014 Fleurier (CH)
(74) Mandataire: Novagraaf International SA

(57) **Abrégé**

L'invention concerne un moule de fabrication d'une pièce d'horlogerie par croissance métallique galvanique ou autocatalytique, comprenant :
- un substrat (10) supportant au moins une couche de résine photosensible (21) texturée,
- au moins une empreinte à remplir par électrodéposition pour former la pièce d'horlogerie, l'empreinte étant définie dans la couche de résine photosensible (21) et comprenant un fond d'empreinte conducteur,
caractérisé en ce que la couche de résine photosensible (21) comprend au moins un rebord (22) qui s'étend au dessus d'une partie de l'empreinte.

## Description

### Domaine technique de l'invention

La présente invention concerne de manière générale les moules pour former des pièces métalliques par galvanoplastie c'est à dire par croissance métallique galvanique ou autocatalytique (par électrodéposition ou bien dépose par un procédé sans courant appelé « electroless » ou dépôt autocatalytique qui crée des dépôts métalliques par réduction chimique autocatalytique de cations métalliques dans un bain liquide) et la fabrication de ces moules. De telles fabrications de moule font typiquement appel à des techniques de photolithographie UV où de la résine photosensible est d'abord déposée sur un substrat puis irradiée au travers d'un masque pour pouvoir faire ensuite une gravure sélective de cette résine afin de générer des empreintes de moulage dans la résine. La présente invention concerne aussi la formation des pièces métalliques dans les moules précités.

### État de la technique

Dans l'art antérieur de fabrication de moules par photolithographie, on connait le document EP1835339A1 qui divulgue des étapes de développement de résine déposée sur un substrat pour former des empreintes destinées à faire croître un dépôt métallique pour former des pièces métalliques de formes complexes. Une fois la résine déposée, il peut être nécessaire de rendre conducteur le fond des empreintes, et il est connu de former une couche conductrice en fond d'empreinte par dépôt physique de métal en phase vapeur. Toutefois, il peut être important de ne pas déposer de métal sur les parois verticales ou flancs de l'empreinte, pour ne pas générer de croissance parasite à partir des parois verticales ou des flancs.

### Exposé de l'invention

Un but de la présente invention est de répondre aux inconvénients de l'art antérieur mentionnés ci-dessus et en particulier, tout d'abord, de proposer un moule pour former des pièces métalliques par galvanoplastie et/ou croissance métallique (galvanique ou autocatalytique), dont les empreintes garantissent une croissance homogène et complète à partir du fond seulement, c'est-à-dire sans croissances parasites à partir des flancs ou des parois verticales. Un objet de l'invention est également de proposer un procédé pour fabriquer de tels moules.

Pour cela un premier aspect de l'invention concerne un moule de fabrication par électrodéposition d'une pièce d'horlogerie, comprenant :
- un substrat supportant au moins une couche de résine photosensible texturée,
- au moins une empreinte à remplir par électrodéposition pour former la pièce d'horlogerie, l'empreinte étant définie dans la couche de résine photosensible et comprenant un fond d'empreinte conducteur,
caractérisé en ce que la couche de résine photosensible comprend au moins un rebord qui s'étend au dessus d'une partie de l'empreinte. Un tel rebord, de préférence ménagé sur la surface supérieure de la résine texturée formant l'empreinte, permet de garantir que le fond d'empreinte peut être rendu conducteur par une métallisation effectuée après la formation de l'empreinte, sans déposer de métal sur les parois verticales ou flancs de l'empreinte. En effet, le rebord en question forme un écran qui empêche le dépôt de matière sur les parois verticales des empreintes.

Selon un mode de réalisation, le moule peut comprendre une pluralité d'empreintes ayant chacune un fond d'empreinte conducteur, les fonds d'empreinte conducteurs étant électriquement reliés entre eux.

Selon un mode de réalisation, le rebord peut former une saillie sur un flanc de l'empreinte. La saillie est de préférence agencée sur la partie supérieure des flancs de l'empreinte, et de préférence sur la surface supérieure de la résine texturée formant l'empreinte.

Selon un mode de réalisation, le rebord peut faire partie d'une surface supérieure de la couche de résine photosensible.

Selon un mode de réalisation, le rebord peut former un surplomb au dessus de l'empreinte d'une dimension de saillie comprise entre 2 µm à 20 µm, et de préférence entre 2 µm et 8µm. Autrement dit, selon une direction horizontale et/ou parallèle au fond de l'empreinte, le rebord peut présenter une dimension ou une taille comprise entre 2 µm à 20 µm, et de préférence entre 2 µm et 8µm. En d'autres termes, selon une direction normale aux flancs de l'empreinte, le rebord peut présenter une dimension ou une taille comprise entre 2 µm à 20 µm, et de préférence entre 2 µm et 8µm. Selon un mode de réalisation, le rebord peut avoir une hauteur ou une épaisseur comprise entre 2 µm à 25 µm, et de préférence entre 2 µm et 8µm. Autrement dit, selon une direction verticale et/ou normale au fond de l'empreinte, le rebord peut présenter une dimension ou une taille comprise entre 2 µm à 25 µm, et de préférence entre 2 µm et 8µm.

On peut prévoir toute méthode connue de mesure de l'épaisseur des couches (réflectométrie, ellipsométrie, TEM (microscopie électronique à transmission), SEM (microscopie électronique à balayage) ou de préférence par des études au microscope optique pour déterminer l'épaisseur des couches - couleurs d'interférence caractéristiques). En particulier, on peut prévoir de mesurer les épaisseurs déposées avec un interféromètre optique du type par exemple Veeco NT3300. On peut aussi prévoir de faire des coupes pour inspecter un moule de manière destructive.

Selon un mode de réalisation, le rebord peut former un surplomb continu au dessus de l'empreinte, le long d'une périphérie de l'empreinte.

Selon un mode de réalisation, le moule peut comprendre une couche conductrice déposée sur le fond d'empreinte et sur les parties supérieures de la couche de résine photosensible.

Un deuxième aspect de l'invention se rapporte à un procédé de fabrication d'un moule pour former une pièce par électrodéposition, comprenant les étapes consistant à :
a- se munir d'un substrat,
b- former au moins une couche de résine photosensible sur le substrat,
c- irradier la couche de résine photosensible au travers d'un masque,
d- imposer une réticulation supplémentaire au moins en surface des parties irradiées de la résine photosensible, avec par exemple un premier traitement thermique à une température comprise entre 20°C et 65°C, de préférence entre 25°C et 65°C.
e- optionnellement, recouvrir la couche de résine photosensible avec une couche de matériau comprenant au moins un solvant,
f- faire un deuxième traitement thermique à une température comprise entre 70°C et 95°C,
g- développer la résine photosensible pour former au moins une empreinte laissant apparaitre le substrat et comprenant un rebord en partie supérieure,
h- former une couche de matière, par exemple conductrice, au moins au fond de l'empreinte et de préférence sur les surfaces supérieures par dépôt physique en phase vapeur.

On peut noter que les étapes mentionnées ci-dessus ne sont pas forcément effectuées de manière séquentielle, ni dans l'ordre indiqué. En particulier, on peut faire se chevaucher des étapes, et/ou les effectuer de manière simultanée, et/ou même les effectuer dans un autre ordre.

Selon un mode de réalisation, l'étape d- peut comprendre une étape consistant à déposer une couche de résine comprenant une proportion ou une concentration de photoamorceurs plus élevée que la couche de résine photosensible de base. Dans ce cas, l'étape d- peut être mise en oeuvre avant ou lors de l'étape c- d'irradiation. Dans ce cas, le premier traitement thermique peut être omis. Aussi, l'étape e- consistant à recouvrir la couche de résine photosensible avec une couche de matériau comprenant au moins un solvant peut être omise.

Autrement dit, si on prévoit de déposer une couche de résine comprenant une proportion ou une concentration de photoamorceurs plus élevée que la couche de résine photosensible de base, le procédé peut être le suivant :
- se munir d'un substrat,
- former au moins une couche de résine photosensible sur le substrat,
- déposer une autre couche de résine comprenant une proportion ou une concentration de photoamorceurs plus élevée que la couche de résine photosensible de base,
- irradier les couches de résine photosensible au travers d'un masque,
- faire un traitement thermique à une température comprise entre 70°C et 95°C,
- développer la résine photosensible pour former au moins une empreinte laissant apparaitre le substrat et comprenant un rebord en partie supérieure,
- former une couche de matière, par exemple conductrice, au moins au fond de l'empreinte et de préférence sur les surfaces supérieures par dépôt physique en phase vapeur.

La demanderesse s'est aperçue que lors de l'irradiation, la couche supérieure (plus concentrée) réagit plus vite et dans une plus grande mesure à l'irradiation que la couche inférieure, si bien que la couche supérieure présente des parties réticulées plus importantes (notamment selon les directions transverses à l'irradiation) que la couche inférieure, formant ainsi des rebords réticulés agencés au dessus de parties non réticulées de la couche inférieure. On peut noter que l'épaisseur de la couche supérieure comprenant une proportion ou une concentration de photoamorceurs plus élevée définira la hauteur précitée des rebords.

Selon une alternative à la mise en oeuvre ci dessus, le procédé peut être le suivant :
- se munir d'un substrat,
- former au moins une couche de résine photosensible sur le substrat,
- irradier la couche de résine photosensible au travers d'un masque,
- déposer une autre couche de résine comprenant une proportion ou une concentration de photoamorceurs plus élevée que la couche de résine photosensible de base,
- irradier les couches de résine photosensibles au travers d'un masque de sorte à ne faire réagir que ladite une autre couche de résine comprenant une proportion ou une concentration de photoamorceurs plus élevée, cette deuxième irradiation pouvant être effectuée avec une longueur d'onde spécifique (par exemple 340 nm - 350 nm pour de la résine SU8) qui pénètre peu dans les résines déposées, et de préférence uniquement dans la couche de résine supérieure, cette deuxième irradiation pouvant être effectuée avec une exposition conduisant à délivrer une énergie d'au plus 75 mJ par cm² de résine exposée, d'au plus 60 mJ par cm² de résine exposée, d'au plus 50 mJ par cm² de résine exposée, d'au plus 40 mJ par cm² de résine exposée, ou conduisant à délivrer une énergie comprise entre 1 mJ et 50 mJ par cm² de résine exposée,
- faire un traitement thermique à une température comprise entre 70°C et 95°C,
- développer la résine photosensible pour former au moins une empreinte laissant apparaitre le substrat et comprenant un rebord en partie supérieure,
- former une couche de matière, par exemple conductrice, au moins au fond de l'empreinte et de préférence sur les surfaces supérieures par dépôt physique en phase vapeur.

Selon un mode de réalisation, l'étape d- peut comprendre une étape consistant à irradier la résine photosensible avec une longueur d'onde spécifique et de préférence avec un masque ayant des ouvertures plus grandes que celles du masque utilisé à l'étape c-. Une telle longueur d'onde spécifique est choisie pour conduire la résine photosensible à réticuler en surface. Dans le cas d'une résine SU-8, on peut prévoir une irradiation avec une longueur d'onde de 340-350 nm à travers un masque avec des ouvertures plus grandes que celles du masque utilisé à l'étape c-. Les rayons avec ces longueurs d'onde proposées pénètrent moins dans le matériau qui ne réticule qu'en surface. Le temps d'exposition doit être suffisamment court pour n'irradier que la surface de la résine. On peut prévoir une exposition conduisant à délivrer une énergie d'au plus 75 mJ par cm² de résine exposée, d'au plus 60 mJ par cm² de résine exposée, d'au plus 50 mJ par cm² de résine exposée, d'au plus 40 mJ par cm² de résine exposée, ou conduisant à délivrer une énergie comprise entre 1 mJ et 50 mJ par cm² de résine exposée. Dans ce cas, le premier traitement thermique peut être omis. Aussi, l'étape e- consistant à recouvrir la couche de résine photosensible avec une couche de matériau comprenant au moins un solvant peut être omise.

Autrement dit, si on prévoit d'effectuer une irradiation avec une longueur d'onde spécifique et de préférence avec un masque ayant des ouvertures plus grandes que celles du masque utilisé à l'étape c-, le procédé peut être le suivant :
- se munir d'un substrat,
- former au moins une couche de résine photosensible sur le substrat,
- irradier la couches de résine photosensible au travers d'un premier masque avec une première longueur d'onde (par exemple 365 nm pour de la résine SU8) puis au travers d'un deuxième masque ayant des ouvertures plus grandes que le premier masque et avec une deuxième longueur d'onde (par exemple située dans un intervalle 340 nm - 350 nm pour de la résine SU8) pénétrant moins dans la résine que la première longueur d'onde,
- faire un traitement thermique à une température comprise entre 70°C et 95°C,
- développer la résine photosensible pour former au moins une empreinte laissant apparaitre le substrat et comprenant un rebord en partie supérieure,
- former une couche de matière, par exemple conductrice, au moins au fond de l'empreinte et de préférence sur les surfaces supérieures par dépôt physique en phase vapeur.

On peut noter que les ouvertures plus grandes du deuxième masque vont définir la taille précitée du rebord, selon la direction transverse à l'irradiation, c'est-à-dire typiquement selon la direction horizontale.

En d'autres termes, selon la mise en oeuvre ci-dessus, l'étape d-comprend une étape consistant à irradier, avec une longueur d'onde spécifique, au moins une partie des zones de résine non irradiées à l'étape cet agencées en périphérie ou adjacentes des zones de résine irradiées à l'étape c-. Ainsi, des rebords sont formés en périphérie ou adjacents aux zones de résine déjà irradiées. Lors de cette étape d'irradiation avec une longueur d'onde spécifique, les zone déjà irradiées sont typiquement irradiées à nouveau. Cependant, les étapes d'irradiation peuvent être inversées.

Selon un mode de réalisation, le premier traitement thermique peut être effectué pendant une durée allant de 5 min à plusieurs jours pour les plus basses températures.

Selon un mode de réalisation, le premier traitement thermique peut être effectué préférentiellement de 40 à 60°C de 30 min à 1h, de sorte à consommer une quantité contrôlée de photo-initiateur afin d'éviter la formation des rebords trop importants dans l'étape f.

Selon un mode de réalisation, le dit au moins solvant utilisé à l'étape e peut permettre la mobilité de photo-initiateurs acides (activés par les UV) et/ou de la résine photosensible du type Su-8 (activés avec les photo-initiateur exposés aux UV). Les solvants peuvent être ceux présent dans la résine : cyclopentanone, PGMEA ; gamma-butyrolactone ... Le dit au moins solvant peut être de l'acétone et/ou un solvant permettant de dissoudre le photo initiateur activé et ou le Su-8 activé.

Selon un mode de réalisation, le deuxième traitement thermique peut être effectué pendant une durée allant de 5 min à 5h.

Selon un mode de réalisation, le dépôt physique en phase vapeur peut être directionnel. Les rebords de résine formés font alors écran (ou « parapluie ») et protègent les flancs d'un dépôt PVD. Les flancs restent ainsi non conducteurs. On peut prévoir d'ajuster l'étape de dépose pour atteindre ou juste dépasser une limite de percolation de conduite de courant électrique au fond des cavités, et pas sur les flancs ou parois verticales des parties activées, afin de ne pas perturber la croissance galvanique en cas de galvanoplastie par électrodéposition. Autrement dit, le fond des cavités est recouvert d'une couche suffisamment épaisse pour pouvoir conduire le courant électrique, alors que les flancs sont exempts de revêtement conducteur ou avec des particules conductrices trop éloignées les unes des autres pour pouvoir conduire le courant électrique. On peut prévoir d'effectuer le dépôt physique de métal sous forme vapeur de manière directionnelle, selon une direction parallèle aux flancs des cavités.

Selon un mode de réalisation, l'étape de formation d'une couche conductrice de recouvrement au fond des cavités peut être effectuée :
- sous niveau de vide inférieur à 10⁻⁴ mbar, et de préférence inférieur à 10⁻⁶ mbar,
- en plaçant par exemple une plaquette de 150 mm de côté ou de diamètre formant le substrat à au moins 500 mm de la source de matière à vaporiser et de préférence à au moins 700 mm de la source de matière à vaporiser, et/ou en chauffant la source de matière à vaporiser juste au dessus de sa température de fusion,
- en utilisant une source métallique pure à 99% au moins, comme par exemple une source d'or pur à 99% en poids.

Selon un mode de réalisation, l'étape f- peut consister à effectuer le deuxième traitement thermique après un temps prédéterminé de recouvrement de la couche de résine photosensible avec la couche de matériau comprenant au moins un solvant.

Selon un mode de réalisation, le temps prédéterminé peut être suffisant pour permettre une diffusion de catalyseurs ou d'agents réactifs dans la résine photosensible depuis une zone irradiée à l'étape c- vers une zone non irradiée à l'étape c-.

Selon un mode de réalisation, le temps prédéterminé peut être compris entre 1 min et 24 h.

Selon un mode de réalisation, le temps prédéterminé peut être suffisant pour permettre une diffusion de catalyseur ou d'agents réactifs sur une distance comprise allant de 2 µm à 20 µm, et de préférence allant de 2 µm à 8µm.

Selon un mode de réalisation, l'étape e- peut consister à recouvrir la couche de résine photosensible avec une couche de matériau comprenant au moins un mélange de solvants.

Selon un mode de réalisation, on peut prévoir d'utiliser un solvant permettant de dissoudre les sels photosensibles et /ou le polymère activé et un autre solvant ne réagissant pas avec le système. Ce mélange de solvant dissout de manière contrôlée (et faiblement) les constituants pour permettre une faible migration des constituants en surface des zones exposées et former ainsi un faible rebord. On peut prévoir par exemple un solvant (pouvant dissoudre les sels photosensibles et /ou le polymère activé) choisi parmi : cyclopentanone, PGMEA, acétone ; gamma-butyrolactone ... On peut prévoir par exemple l'Isopropylalcool comme solvant ne réagissant pas.

Selon un mode de réalisation, l'étape e- consiste à recouvrir la couche de résine photosensible avec un gel comprenant au moins un solvant.

Selon un mode de réalisation pour former un gel ou mélange visqueux de solvant, on peut par exemple prévoir de dissoudre dans un solvant (ou un mélange de solvant) un polymère ne réagissant pas avec le système, comme par exemple le polyéthylène glycol ou PEG ou encore la polyvinylpyrrolidone

(PVP) ... Un mélange visqueux est plus facile à déposer et les moules après dépôt sont plus faciles à manipuler

Selon un mode de réalisation, l'étape e- peut consister à recouvrir la couche de résine photosensible avec une résine photosensible comprenant au moins un solvant. Un solvant permettant de dissoudre les sels photosensibles et /ou le polymère activé et un autre solvant ne réagissant pas avec le système. Ce mélange de solvant dissout de manière contrôlée (et faiblement) les constituants pour permettre une faible migration des constituants en surface des zones exposées et former ainsi un faible rebord.

On peut prévoir par exemple un solvant (pouvant dissoudre les sels photosensibles et /ou le polymère activé) choisi parmi : cyclopentanone, PGMEA, acétone ; gamma-butyrolactone ... On peut prévoir par exemple l'Isopropylalcool comme solvant ne réagissant pas.

Selon un mode de réalisation, la résine photosensible peut être composée de résine époxyde, de carbonate de propylène, d'un amorceur triaryl-sulfonium et d'un solvant organique (cyclopentanone ou gamma-butyrolactone), comme par exemple une résine de type SU-8.

Selon un mode de réalisation, la couche de résine photosensible peut être déposée à l'étape b- sur une surface du substrat non conductrice de l'électricité.

Un troisième aspect de l'invention se rapporte à un procédé de fabrication d'une pièce horlogère, comprenant les étapes consistant à :
- fournir un moule fabriqué avec le procédé de fabrication selon le deuxième aspect,
- fabriquer la pièce horlogère par croissance métallique galvanique ou autocatalytique dans l'empreinte du moule.

### Description des figures

D'autres caractéristiques et avantages de la présente invention apparaîtront plus clairement à la lecture de la description détaillée qui suit d'un mode de réalisation de l'invention donné à titre d'exemple nullement limitatif et illustré par les dessins annexés, dans lesquels :
[fig. 1] représente une étape d'un procédé de fabrication d'un moule selon l'invention avec la fourniture d'un substrat conducteur ;
[fig. 2] représente une autre étape du procédé de fabrication d'un moule selon l'invention avec la formation d'une couche épaisse de résine photosensible sur le substrat ;
[fig. 3] représente une autre étape du procédé de fabrication d'un moule selon l'invention avec l'irradiation sélective de la couche épaisse de résine photosensible ;
[fig. 4] représente une autre étape du procédé de fabrication d'un moule selon l'invention avec la dépose d'une couche solvantée au dessus de la couche épaisse de résine photosensible ;
[fig. 5] représente une autre étape du procédé de fabrication d'un moule selon l'invention avec le développement de la couche épaisse de résine photosensible ;
[fig. 6] représente une autre étape du procédé de fabrication d'un moule selon l'invention avec le dépôt physique d'un métal en phase vapeur au fond de cavités de la couche épaisse de résine photosensible développée.

### Description détaillée de mode(s) de réalisation

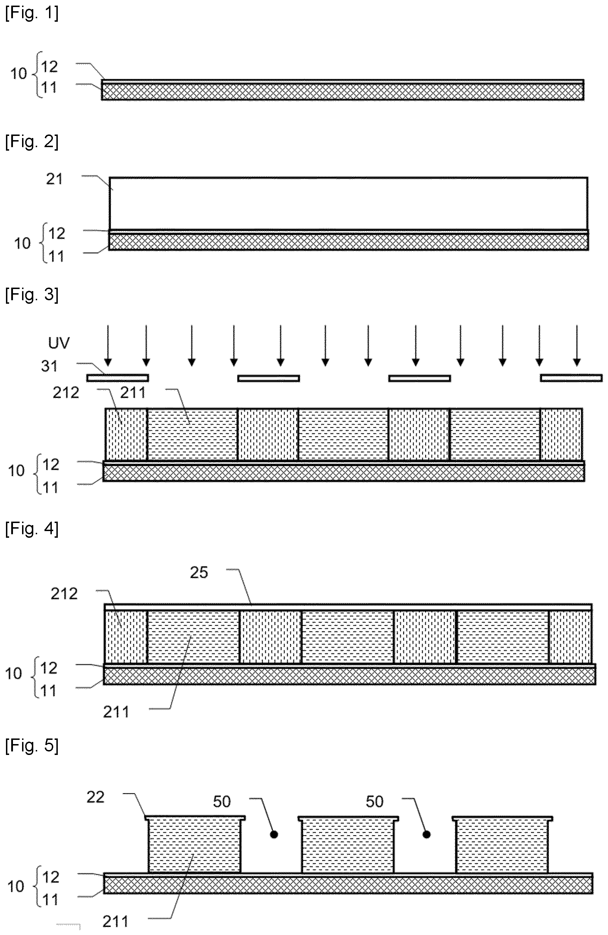

La figure 1 représente une première étape qui consiste à se munir d'un substrat 10 comprenant une âme 11 en silicium et une couche conductrice de base 12.

L'âme 11 est une plaquette en silicium, mais on peut envisager d'utiliser une plaquette en verre, ou une plaquette en céramique ou même une plaquette métallique. La couche conductrice de base 12 peut comprendre une sous couche de chrome ou de titane et une couche d'or ou de cuivre.

On peut noter que la couche conductrice de base 12 est optionnelle et peut être omise.

La figure 2 représente le moule de la figure 1 recouvert d'une couche épaisse de résine photosensible 21 qui formera en tout ou partie le moule à proprement parler. On peut appliquer une résine photosensible 21 liquide ou visqueuse, par exemple à la tournette ou par application au cylindre, ou on peut alternativement déposer / laminer une couche de résine solide du type lamina (un film sec ou une feuille sèche de résine, à laminer).

La résine photosensible 21 est une résine photosensible négative couramment utilisée dans la fabrication de microsystèmes. Il s'agit d'un polymère très visqueux qui peut être tourné (dépose à la tournette) ou étalé sur une épaisseur allant de 1 micromètre à 2 millimètres. On peut par exemple utiliser une résine SU-8 composée de résine époxyde, de carbonate de propylène, de l'amorceur triaryl-sulfonium et d'un solvant organique (cyclopentanone ou gamma-butyrolactone, selon la formulation). On peut ensuite effectuer un chauffage ou un recuit (« pre-bake ») pour évaporer le ou les solvants et pour solidifier la résine.

On peut déposer la résine photosensible 21 en une ou plusieurs fois, sous forme visqueuse ou liquide ou encore solide (un film sec ou une feuille sèche de résine non réticulée, à laminer) , mais on peut également déposer une couche de résine photosensible 21 polymérisée et préparée à l'avance.

La figure 3 montre l'étape d'irradiation à un rayonnement UV de la résine photosensible 21 au travers d'un masque 31, pour activer ou réticuler les parties de la résine photosensible 21 en regard des ouvertures du masque 31. Pour la résine SU-8 susmentionnée, on peut effectuer une irradiation à un rayonnement UV de longueur d'onde de 365 nm.

Comme le montre la figure 3, la résine photosensible 21 présente alors des parties activées 211 et des parties non activées 212. A l'issue de l'étape d'irradiation, un recuit peut encore être effectué.

Au lieu de passer à l'étape de développement de la résine photosensible 21, il est proposé de réaliser un premier traitement thermique à une température comprise entre 25°C et 65°C et de déposer sur la résine photosensible 21 partiellement réticulée une couche solvantée 25 (c'est-à-dire une couche formée par un matériau comprenant au moins un solvant pouvant dissoudre les sels activés ou le polymère activé), comme le montre la figure 4, puis de faire un deuxième traitement thermique à une température comprise entre 70°C et 95°C.

Selon un mode de réalisation, le premier traitement thermique peut être omis et remplacé par une étape consistant à déposer une couche de résine comprenant une proportion de photoamorceurs plus élevée que la couche de résine photosensible de base 21 déposée à la figure 2. Dans ce cas, cette étape peut être mise en oeuvre avant l'étape d'irradiation de la figure 3.

Selon un mode de réalisation, le premier traitement thermique peut être omis et remplacé par une étape consistant à irradier la résine photosensible avec une longueur d'onde spécifique. Dans le cas d'une résine SU-8, on peut prévoir une irradiation avec une longueur d'onde de 340-350 nm à travers un masque avec des ouvertures plus grandes que celles du masque utilisé à l'étape d'irradiation de la figure 3. Les rayons avec ces longueurs d'onde proposées pénètrent moins dans le matériau qui ne réticule qu'en surface. Le temps d'exposition doit être suffisamment court pour n'irradier que la surface de la résine.

Le but de ces opérations est de provoquer une migration ou une diffusion des acides photo-initiateurs présents dans les parties activées 211 vers les parties non activées 212, afin d'étendre depuis les parties activées 211 la réticulation de la résine horizontalement et sur une couche proche de la surface.

D'une manière générale, le premier traitement thermique est effectué pendant une durée allant de 5 min à plusieurs jours pour les plus basses températures. Le premier traitement thermique est effectué préférentiellement de 40 à 60°C de 30 min à 1h. Ce premier traitement thermique a pour effet de provoquer une réticulation plus complète de la résine photosensible 21, pour éviter qu'une trop grande quantité acides photo-initiateurs ne migre vers les parties non activées 212.

En ce qui concerne la couche solvantée 25, celle-ci a pour fonction de provoquer et/ou permettre et/ou véhiculer la migration ou la diffusion des acides photo-initiateurs vers les parties non activées 212. On peut prévoir pour la couche solvantée 25 de simplement déposer de la résine photosensible liquide, ou un gel comprenant un solvant ou un mélange de solvants ou directement un solvant ou un mélange de solvants. Dans le détail, on peut prévoir d'utiliser au moins un premier solvant permettant de dissoudre les sels photosensibles et /ou le polymère activé de la couche épaisse de résine photosensible 21 et un deuxième solvant ne réagissant pas avec le système (pour contrôler et/ou ajuster le pouvoir de dissolution du premier solvant). Ce mélange de solvants dissout de manière contrôlée (et faiblement) les constituants pour permettre une faible migration des constituants en surface des zones exposées et former ainsi un faible rebord. On peut prévoir par exemple un solvant (pouvant dissoudre les sels photosensibles et /ou le polymère activé) choisi parmi : cyclopentanone, PGMEA, acétone ; gamma-butyrolactone ... On peut prévoir par exemple l'Isopropylalcool comme solvant ne réagissant pas.

En ce qui concerne les modes de réalisation avec un gel, en particulier pour former un gel ou un mélange visqueux de solvant, on peut par exemple prévoir de dissoudre dans un solvant (ou un mélange de solvant) un polymère ne réagissant pas avec le système, comme par exemple le polyéthylène glycol ou PEG ou encore la polyvinylpyrrolidone (PVP) ... Un mélange visqueux est plus facile à déposer et les moules après dépôt sont plus faciles à manipuler.

En ce qui concerne le deuxième traitement thermique il peut être effectué pendant une durée allant de 5 min à 5h, pour permettre la réticulation des zones des parties non activées 212 qui ont reçu des acides photo-initiateurs. Ainsi, en surface de la résine photosensible 21, les parties activées 211 « débordent » désormais sur les parties non activées 212 avec des rebords 22 qui restent en place après développement comme le montre la figure 5.

Les rebords 22 de la figure 5 présentent une dimension horizontale comprise entre 2 µm à 20 µm, et de préférence entre 2 µm et 8µm. On peut noter que cette dimension peut être ajustée au moins par :
- la durée et la température du premier traitement thermique (plus ce dernier sera chaud et long, plus les rebords seront étroits car la migration sera rendue plus difficile),
- la durée laissée entre le premier traitement thermique et le deuxième traitement thermique (plus la couche solvantée sera laissée longtemps sur la résine photosensible 21 avant le deuxième traitement thermique, plus les rebords seront larges),
- la quantité et la nature des solvants utilisés.

Après le deuxième traitement thermique appliqué sur le moule de la figure 4, on peut procéder au développement dans un bain de solvant (par exemple du Propylène glycol méthyl éther acétate pour la résine SU-8). A l'issue du développement, les parties non activées 212 sont dissoutes et le moule de la figure 5 est obtenu.

On peut noter que les parties activées 211 munies des rebords 22 forment des motifs en relief, entourant des cavités 50 qui laissent apparaître la couche conductrice de base 12 (qui est optionnelle comme expliqué ci-dessus). Les cavités 50 forment typiquement une ou plusieurs empreinte(s) pour réaliser la déposition de métal et former ainsi des pièces métalliques par galvanoplastie et/ou croissance métallique .

On peut noter que l'exemple décrit fait appel à une résine négative, mais on peut envisager d'utiliser une résine positive. De plus, il est possible de déposer, irradier et développer successivement plusieurs couches de résine photosensible pour créer un moule multi niveaux. Dans ce cas, on peut prévoir de former des rebords 22 sur chaque couche épaisse de résine photosensible, et /ou uniquement sur le haut des structures du dernier niveau.

Même si dans l'exemple représenté le fond des cavités 50 est normalement formé par la couche conductrice de base 12, cette dernière peut être absente ou recouverte de résidus non conducteurs qui affecteront la croissance galvanique.

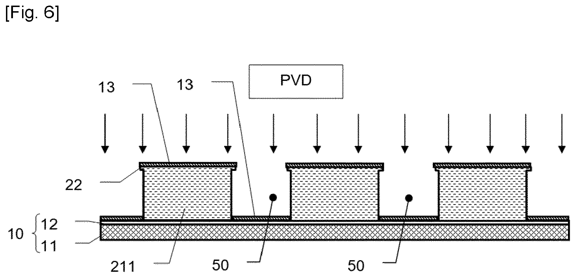

La figure 6 représente le moule de la figure 5 auquel on applique une étape de dépôt physique de métal sous forme vapeur, pour déposer par exemple de l'or au fond des cavités 50 pour former une couche conductrice de recouvrement 13. On peut prévoir d'ajuster l'étape de dépose pour atteindre ou juste dépasser une limite de percolation de conduite de courant électrique au fond des cavités 50, et pas sur les flancs ou parois verticales des parties activées 211, afin de ne pas perturber la croissance galvanique en cas de galvanoplastie par électrodéposition. Autrement dit, le fond des cavités 50 est recouvert d'une couche suffisamment épaisse pour pouvoir conduire le courant électrique, alors que les flancs sont exempts de revêtement conducteur ou avec des particules conductrices trop éloignées les unes des autres pour pouvoir conduire le courant électrique. On peut prévoir d'effectuer le dépôt physique de métal sous forme vapeur de manière directionnelle, selon une direction parallèle aux flancs des cavités 50.

Selon un mode de réalisation, l'étape de formation d'une couche conductrice de recouvrement 13 au fond des cavités 50 peut être effectuée :
- sous niveau de vide inférieur à 10⁻⁴ mbar, et de préférence inférieur à 10⁻⁶ mbar,
- en plaçant par exemple une plaquette de 150 mm de côté ou de diamètre formant le substrat à au moins 500 mm de la source de matière à vaporiser et de préférence à au moins 700 mm de la source de matière à vaporiser, et/ou en chauffant la source de matière à vaporiser juste au dessus de sa température de fusion,
- en utilisant une source métallique pure à 99% au moins, comme par exemple une source d'or pur à 99% en poids.

Une telle couche conductrice de recouvrement 13 a pour effet de permettre une croissance homogène depuis toute la surface inférieure, si le substrat 10 est exempt de de couche conductrice de base 12, ou pour garantir une croissance homogène si la couche conductrice de base 12 est présente mais recouverte par endroits ou en totalité par des résidus. Lors de cette étape de dépôt physique en phase vapeur, qui est directionnel (selon la direction verticale de la figure 6), la présence des rebords 22 garantit l'absence de dépôt métallique sur les flancs ou les parois verticales des cavités 50. Ainsi, la couche conductrice de recouvrement 13 recouvre le fond des cavités 50 et la surface supérieure des parties activées 211 et pas les flancs verticaux, si bien que la croissance dans les cavités 50 lors d'une électrodéposition se fera de manière homogène à partir du fond des cavités 50, sans croissance parasite depuis les parois verticales.

### Application industrielle

Un procédé de fabrication de moule selon la présente invention, et l'utilisation de ces moules pour former des pièces métalliques, sont susceptibles d'application industrielle.

On comprendra que diverses modifications et/ou améliorations évidentes pour l'homme du métier peuvent être apportées aux différents modes de réalisation de l'invention décrits dans la présente description sans sortir du cadre de l'invention.

## Revendications

1. Moule de fabrication par électrodéposition d'une pièce d'horlogerie, comprenant :
- un substrat (10) supportant au moins une couche de résine photosensible (21) texturée,
- au moins une empreinte à remplir par électrodéposition pour former la pièce d'horlogerie, l'empreinte étant définie dans la couche de résine photosensible (21) et comprenant un fond d'empreinte conducteur,
**caractérisé en ce que** la couche de résine photosensible (21) comprend au moins un rebord (22) qui s'étend au dessus d'une partie de l'empreinte.

2. Moule selon la revendication 1, dans lequel le rebord (22) forme une saillie sur un flanc de l'empreinte.

3. Moule selon la revendication 1 ou 2, dans lequel le rebord (22) fait partie d'une surface supérieure de la couche de résine photosensible (21).

4. Moule selon l'une des revendications 1 à 3, dans lequel le rebord (22) forme un surplomb au dessus de l'empreinte d'une dimension de saillie comprise entre 2 µm à 20 µm, et de préférence entre 2 µm et 8µm.

5. Moule selon l'une des revendications 1 à 4, dans lequel le rebord (22) forme un surplomb continu au dessus de l'empreinte, le long d'une périphérie de l'empreinte.

6. Moule selon l'une des revendications 1 à 5, comprenant une couche conductrice de recouvrement (14) déposée sur le fond d'empreinte et sur les parties supérieures de la couche de résine photosensible (21).

7. Procédé de fabrication d'un moule pour former une pièce par électrodéposition, comprenant les étapes consistant à :
a- se munir d'un substrat (10),
b- former au moins une couche de résine photosensible (21) sur le substrat (10),
c- irradier la couche de résine photosensible (21) au travers d'un masque,
d- imposer une réticulation supplémentaire au moins en surface des parties irradiées de la résine photosensible, avec par exemple un premier traitement thermique à une température comprise entre 20°C et 65°C.
e- optionnellement, recouvrir la couche de résine photosensible (21) avec une couche de matériau (25) comprenant au moins un solvant,
f- faire un deuxième traitement thermique à une température comprise entre 70°C et 95°C,
g- développer la résine photosensible (21) pour former au moins une empreinte laissant apparaitre le substrat (10) et comprenant un rebord (22) en partie supérieure,
h- former une couche de matière au moins au fond de l'empreinte et de préférence sur les surfaces supérieures par dépôt physique en phase vapeur.

8. Procédé de fabrication selon la revendication 7, dans lequel l'étape f- consiste à effectuer le deuxième traitement thermique après un temps prédéterminé de recouvrement de la couche de résine photosensible (21) avec la couche de matériau (25) comprenant au moins un solvant.

9. Procédé de fabrication selon la revendication 8, dans lequel le temps prédéterminé est suffisant pour permettre une diffusion de catalyseurs ou d'agents réactifs dans la résine photosensible (21) depuis une zone irradiée à l'étape c- vers une zone non irradiée à l'étape c-.

10. Procédé de fabrication selon la revendication 8 ou 9, dans lequel le temps prédéterminé est suffisant pour permettre une diffusion de catalyseur ou d'agents réactifs sur une distance comprise allant de 2 µm à 20 µm, et de préférence allant de 2 µm à 8µm.

11. Procédé de fabrication selon l'une des revendications 7 à 10, dans lequel l'étape e- consiste à recouvrir la couche de résine photosensible (21) avec une couche de matériau (25) comprenant au moins un mélange de solvants.

12. Procédé de fabrication selon l'une des revendications 7 à 11, dans lequel l'étape e- consiste à recouvrir la couche de résine photosensible (21) avec un gel comprenant au moins un solvant.

13. Procédé de fabrication selon l'une des revendications 7 à 11, dans lequel l'étape e- consiste à recouvrir la couche de résine photosensible (21) avec une résine photosensible comprenant au moins un solvant.

14. Procédé de fabrication selon l'une des revendications 7 à 13, dans lequel la résine photosensible (21) est composée de résine époxyde, de carbonate de propylène, d'un amorceur triaryl-sulfonium et d'un solvant organique (cyclopentanone ou gamma-butyrolactone), comme par exemple une résine SU-8.

15. Procédé de fabrication selon l'une des revendications 7 à 14, dans lequel la couche de résine photosensible (21) est déposée à l'étape b- sur une surface du substrat (10) non conductrice de l'électricité.

16. Procédé de fabrication selon l'une des revendications 7 à 15, dans lequel l'étape d- est effectuée avant ou après l'étape c- d'irradiation et comprend une étape consistant à déposer une couche de résine comprenant une proportion ou une concentration de photoamorceurs plus élevée que la couche de résine photosensible formée à l'étape b-.

17. Procédé de fabrication selon l'une des revendications 7 à 16, dans lequel l'étape d- est effectuée avant ou après l'étape c- d'irradiation et comprend une étape consistant à irradier, avec une longueur d'onde spécifique, au moins une partie des zones de résine non irradiées à l'étape cet agencées en périphérie ou adjacentes des zones de résine irradiées à l'étape c-.

18. Procédé de fabrication d'une pièce horlogère, comprenant les étapes consistant à :
- fournir un moule fabriqué avec le procédé de fabrication selon l'une des revendications 7 à 17,
- fabriquer la pièce horlogère par croissance métallique galvanique ou autocatalytique dans l'empreinte du moule.
